# EUROPÄISCHE PATENTSCHRIFT

(11) **EP 3 084 524 B1**
(45) Veröffentlichungstag und Bekanntmachung des Hinweises auf die Patenterteilung: **14.11.2018**
(21) Anmeldenummer: 14812423.3
(22) Anmeldetag: 04.12.2014
(51) Int. Cl.: G03F 7/16, H01L 31/0216, H01J 9/20, B05C 3/18, B05C 9/02, B05D 1/26, B05C 11/04

(54) **VORRICHTUNG ZUM BESCHICHTEN VON PLANAREN SUBSTRATEN**
APPARATUS FOR COATING FLAT SUBSTRATES
DISPOSITIF DE REVÊTEMENT DE SUBSTRATS PLANAIRES

(30) Priorität: 20.12.2013 DE 102013114718
(43) Veröffentlichungstag der Anmeldung: 26.10.2016
(73) Patentinhaber: Leibniz-Institut für Neue Materialien gemeinnützige GmbH, 66123 Saarbrücken (DE)
(72) Erfinder: DE OLIVEIRA, Peter, William, 66123 Saarbrücken (DE); JILAVI, Mohammad, Hossein, 66459 Kirkel (DE); SCHÄFER, Bruno, 66679 Losheim (DE); SCHMITT, Karl, Peter, F-57520 Grosbliederstroff (FR); DRUMM, Robert, 66113 Saarbrücken (DE); BEERMANN, Herbert, 66806 Ensdorf (DE); SERWAS, Dietmar, 66299 Friedrichsthal (DE)
(74) Vertreter: Patentanwälte Gierlich & Pischitzis Partnerschaft mbB
(86) Internationale Anmeldenummer: PCT/EP2014/076523
(87) Internationale Veröffentlichungsnummer: WO 2015/090992

(56) Entgegenhaltungen:
- EP-A2- 1 634 655
- FR-A1- 2 453 684
- US-A- 4 993 354
- US-A- 5 965 209
- US-A1- 2003 134 049

## Beschreibung

### Gebiet der Erfindung

Die Erfindung betrifft eine Vorrichtung zur Beschichtung von planaren Substraten, bei dem ein Beschichtungskopf mit einer Vertiefung relativ zu einem Substrat bewegt wird.

### Stand der Technik

Antireflexschichten werden für verschiedene Anwendungsfelder eingesetzt, bspw. auf Feldern, bei denen ein höherer Lichtdurchfluss bzw. eine verringerte Lichtreflexion am Substrat erwünscht ist. So werden bspw. bei der Herstellung von Brillen, Displays oder Architekturgläsern, in der Automobilindustrie (bspw. bei Front- oder Rückscheiben), bei der Herstellung von Solarpanel oder Solarzellen, die für die Gewinnung der Solarenergie eingesetzt werden, Antireflexschichten als Grundausstattung berücksichtigt. In den letzten 20 Jahren ist intensiv daran geforscht worden, alternative Beschichtungsverfahren zum üblichen PVD- und CVD-Verfahren zu finden, da diese aufgrund der eingesetzten Vakuumtechnologie immense Investitionskosten benötigen um großflächige Substrate zu verarbeiten. Sol-Gel-Verfahren bieten sich als Alternative, insbesondere unter Berücksichtigung ihrer Wirtschaftlichkeit, an. Für großflächige Substrate bieten sich hierbei insbesondere Dip Outing (Tauchverfahren) an. Allerdings muss bei einem solchen Verfahren das gesamte (großflächige) Substrat in ein Sol eingetaucht werden. Daher werden auch bei sehr dünnen Schichten große Mengen an Sol benötigt. Gleichzeitig kommt es auf dem Substrat zur Ausbildung einer keilförmigen Schicht, d.h. die Schicht am unteren Ende des Substrats ist dicker als im oberen Bereich des Substrats. Weiterhin werden beim Tauchverfahren üblicherweise beide Seiten des Substrats beschichtet. Eine - gewünschte - einseitige Beschichtung ist ohne besondere Vorkehrungen nicht möglich.

EP1634655A2 offenbart eine Vorrichtung zur Beschichtung von Substraten mit einer seitlich geöffneten Rinne zur Meniskusbeschichten von Substraten.

Es ist daher Aufgabe der Erfindung eine Vorrichtung anzugeben, welche die genannten Nachteile des Tauchverfahrens nicht aufweist und bei Verwendung einer deutlich geringeren Sol-Menge die Erzeugung homogener Beschichtungen ermöglicht.

### Lösung

Diese Aufgabe wird durch die Erfindungen mit den Merkmalen der unabhängigen Ansprüche gelöst. Vorteilhafte Weiterbildungen der Erfindungen sind in den Unteransprüchen gekennzeichnet. Der Wortlaut sämtlicher Ansprüche wird hiermit durch Bezugnahme zum Inhalt dieser Beschreibung gemacht. Die Erfindungen umfassen auch alle sinnvollen und insbesondere alle erwähnten Kombinationen von unabhängigen und/oder abhängigen Ansprüchen.

Die Aufgabe wird durch eine Vorrichtung zum Auftragen einer Beschichtungszusammensetzung auf eine planare Oberfläche gemäß Anspruch 1.

Die genannte Vorrichtung bietet den Vorteil, dass auf einfache Weise Schichten auf ein Substrat aufgebracht werden können, ohne dass eine große Menge an Beschichtungszusammensetzung verwendet werden muss. Außerdem ist es deutlich einfacher möglich, die Qualität der Beschichtung durch Änderung der Verfahrensparameter zu variieren.
Als ein weiterer Vorteil ermöglicht die erfindungsgemäße Vorrichtung die einseitige Beschichtung des Substrats. Bei üblichen Tauchbeschichtungen müssen immer beide Seiten des Substrats beschichtet werden. Auch ermöglicht es die Vorrichtung, die Beschichtung nur in bestimmten Bereichen des Substrats aufzutragen.
Um eine Beschichtung aufzutragen, wird die Beschichtungszusammensetzung in die Vertiefung in dem Beschichtungskopf gefüllt. Dieser ist so gegenüber dem Substrat angeordnet, dass die Beschichtungszusammensetzung das Substrat vernetzt. Gleichzeitig ist der Beschichtungskopf bzw. die Öffnung der Vertiefung zur Oberfläche des Substrats, so dicht an dem Substrat angeordnet, dass es durch die Grenzflächenspannung der Beschichtungszusammensetzung nicht zu einem Auslaufen der Beschichtungszusammensetzung kommt. Dadurch wird eine Berührung des Substrats durch den Beschichtungskopf vermieden. Die benetzte Oberfläche des Substrats bildet dabei eine Begrenzung der Vertiefung. Auf den anderen Seiten ist die Vertiefung durch den Beschichtungskopf begrenzt.

Der minimale Abstand zwischen dem Beschichtungskopf bzw. der unteren Begrenzung der Vertiefung und der Oberfläche des Substrats beträgt dabei bevorzugt unter 2500 µm, bevorzugt unter 2000 µm. In einer Ausführungsform der Erfindung beträgt der Abstand zwischen Beschichtungskopf bzw. der unteren Begrenzung der Vertiefung und der Oberfläche des Substrats zwischen 0,1 µm und 2000 µm.

Der ideale Abstand des Beschichtungskopf und des Substrats ist natürlich auch von der Art der Beschichtungszusammensetzung bzw. ihrer Viskosität oder der Grenzflächenspannung abhängig. Auch kann eine Beschichtung der Oberfläche der Vertiefung und/oder der Oberfläche des Substrats den idealen Abstand beeinflussen.

Die Vertiefung in dem Beschichtungskopf ist daher so geformt, dass an der Oberfläche des Substrats ähnliche Bedingungen wie bei einer Tauchbeschichtung vorliegen. Dies wird insbesondere durch die nach oben offene Vertiefung erreicht. Eine in die Vertiefung gefüllte Beschichtungszusammensetzung benetzt auch die Oberfläche des Substrats. An der Grenzfläche von Atmosphäre, Substrat und Beschichtungszusammensetzung kommt es aufgrund der Grenzflächenspannungen zur Verformung der Oberfläche der Beschichtungszusammensetzung. Bei der relativen Bewegung des Substrats wird die Beschichtungszusammensetzung an der Grenzfläche ebenfalls verformt. Die Vertiefung weist bevorzugt senkrecht zur Oberfläche der Vertiefung eine ausreichende Ausdehnung aus, so dass sich in einem Bereich eine Oberfläche ausbilden kann, welche nicht von der Grenzflächenspannung des Substrats beeinflusst wird.

Die Vertiefung im Beschichtungskopf ist bevorzugt deutlich breiter als ihre maximale Tiefe. Bevorzugt ist ein Verhältnis der Breite zur Tiefe von mindestens 1:1, bevorzugt von mindestens 5:1. Dabei bedeutet Tiefe die senkrechte (lotrechte) Ausdehnung der Vertiefung.

Der Beschichtungskopf und/oder das Substrat werden nun relativ zueinander bewegt. Dabei enthält diese relative Bewegung immer eine Komponente, welche senkrecht, d.h. parallel zur Lotrichtung, ist. Auf diese Weise bildet sich an der Grenzfläche zwischen Beschichtungszusammensetzung und Substrat mindestens ein Meniskus aus. Durch die relative Bewegung kommt es zum Auftragen einer dünnen Schicht der Beschichtungszusammensetzung auf das Substrat.

Die Vorrichtung umfasst daher entsprechende Mittel zur Ausführung dieser relativen Bewegung. Dies können beispielsweise Seilzug- und/oder Zahnradantriebe sein.

In einer Ausführungsform der Erfindung resultiert aus der relativen Bewegung eine Bewegung des Beschichtungskopfs entlang der Oberfläche des Substrats parallel zur Lotrichtung.

Die auf diese Weise erhaltene Beschichtung ist ähnlich einer durch ein Tauchverfahren erhaltenen Beschichtung, da das Verfahren auf den gleichen Prinzipien beruht.

Es ist dabei unerheblich, ob der Beschichtungskopf oder das Substrat bewegt wird.

Die Schichtdicke und der Schichtverlauf können in der erfindungsgemäßen Vorrichtung insbesondere durch den Abstand zwischen Beschichtungskopf und Substrat, der Zusammensetzung der Beschichtungszusammensetzung, sowie der Geschwindigkeit der relativen Bewegung eingestellt werden.

Bevorzugt ist eine relative Bewegung von mindestens 0,1 mm/s, bevorzugt mindestens 0,5 mm/s. In einer Ausführungsform der Erfindung liegt die relative Bewegung zwischen 0,5 mm/s und 200 mm/s, bevorzugt zwischen 0,5 mm/s und 100 mm/s.

Die Vertiefung im Beschichtungskopf dient auch gleichzeitig als Reservoir für die Beschichtungszusammensetzung. Der Beschichtungskopf kann allerdings noch Mittel aufweisen, durch welche eine oder mehrere neue Beschichtungszusammensetzung(en) in die Vertiefung eingebracht werden kann/können, sodass ein kontinuierlicher Prozess ermöglicht wird.

Um beispielsweise die Exklusivität der Beschichtungszusammensetzung besser beeinflussen zu können, kann der Beschichtungskopf auch Mittel zur Regelung der Temperatur enthalten. So kann die Beschichtungszusammensetzung auf eine bestimmte Temperatur erwärmt oder gekühlt werden.

Die Beschichtungszusammensetzung kann eine beliebige Beschichtungszusammensetzung sein. Bevorzugt sind Sole oder Sol-Gel-Zusammensetzungen. Diese werden insbesondere zur Herstellung von Antireflexions- oder Antikratzbeschichtungen verwendet.

Die für die Erfindung verwendeten Zusammensetzungen weisen bevorzugt eine Viskosität zwischen 2 bis 40 mPa*s, bevorzugt zwischen 5 und 20 mPa*s auf.

Besonders bevorzugt umfassen die Beschichtungszusammensetzungen Sole von Metall- oder Halbmetallverbindungen. Besonders bevorzugt sind Beschichtungszusammensetzungen umfassend Verbindungen von mindestens eines der Elemente der Hauptgruppen III bis V des Periodensystems, zum Beispiel Al, Si, In und/oder der Nebengruppen II bis V des Periodensystems, zum Beispiel Sn, Ti, Zn, Zr, Nb, Ta, V und/oder Verbindungen der Lanthaniden, wie etwa Ce. Die Beschichtungszusammensetzung kann auch Gemische solcher Verbindungen enthalten oder auch weitere Verbindungen von Elementen der Hauptgruppen I und II des Periodensystems, z. B. Na, Ca, Mg und der Nebengruppen VI bis VIII des Periodensystems, wie beispielsweise Mn, Cr, Ni aufweisen.

Besonders bevorzugt sind Beschichtungszusammensetzungen umfassend Sole der Oxide der Metalle, bzw. Halbmetalle Ti, Si, Nb, Ta, Al oder Zr.

Die Beschichtungszusammensetzung kann beliebige Lösungsmittel enthalten. Bevorzugt sind für Beschichtungen übliche Lösungsmittel. Dies kann beispielsweise Wasser sein. Als organische Lösungsmittel eignen sich sowohl polare als auch unpolare aprotische Lösungsmittel. Beispiele hierfür sind Alkohole, vorzugweise niedere aliphatische Alkohole (C₁-C₈-Alkohole), wie Methanol, Ethanol, 1-Propanol, i-Propanol und 1-Butanol, Ketone, vorzugsweise aliphatische Ketone, wie Aceton, Methylketon, Methylisobutylketon, Ester, wie 2-Methoxypropylacetat, Butylacetat und Ethylacetat, Ether, vorzugsweise niedere Dialkylether, wie Diethylether, cyclische Ether wie Dioxan oder THF, oder Monoether von Diolen, wie Ethylenglycol oder Propylenglycol, mit C₁-C₈-Alkoholen, aromatische oder aliphatische Kohlenwasserstoffe, wie Hexan, Heptan, Petrolether, Toluol und Xylol, Amide, wie Dimethylformamid, und deren Gemische. Bevorzugt sind protische und/oder polare Lösungsmittel wie aliphatisehe Alkohole, besonders bevorzugt mit 1 bis 4 Kohlenstoffatomen.

Mit der erfindungsgemäßen Vorrichtung können Beschichtungen mit einer Schichtdicke (nach Trocknung und evtl. Nachbehandlung) von unter 500 nm erhalten werden, bevorzugt zwischen 20 und 500 nm. Für diese Schichten wird nicht nur eine im Vergleich zur Tauchbeschichtung deutlich geringere Menge an Beschichtungszusammensetzung benötigt. Sie weisen außerdem eine deutlich verbesserte Homogenität insbesondere der Schichtdicke auf.

Die Vertiefung im Beschichtungskopf kann dabei unterschiedlich geformt sein. Sie kann eine rechteckige Form aufweisen. Es ist aber auch erfindungsgemäß umfasst, dass die Vertiefung eine zum Substrat hin zunehmende Tiefe aufweist.

In einer weiteren Ausführungsform der Erfindung weist die Vertiefung zum Substrat hin eine nicht linear zunehmende Tiefe auf, bevorzugt weist die Vertiefung eine stetige nicht linear zunehmende Tiefe auf, besonders bevorzugt auch eine stetig zunehmende Tiefe.

In einer weiteren Aufführungsform der Erfindung weist die Vertiefung zum Substrat hin eine zunehmende Tiefe auf, wobei der Boden der Vertiefung in Richtung des Substrats konkav geformt ist. Im Querschnitt bildet der Boden der Vertiefung einen Teil einer konkaven Funktion. Bevorzugt bleibt die Krümmung des Bodens der Vertiefung in Richtung des Substrats gleich und/oder nimmt zum Substrat hin zu.

Dies führt zu einem konkav gekrümmten Boden der Vertiefung. Dadurch kann das Volumen der Vertiefung und damit die benötigte Menge an Sol nochmal deutlich reduziert werden, ohne dass sich die Qualität der Beschichtung ändert. Auch bleiben im Verhältnis zu den anders geformten Vertiefungen die benetzte Fläche auf dem Substrat und die nach oben offene Oberfläche der Beschichtungszusammensetzung in der Vertiefung gleich. Diese nach oben offene Fläche bestimmt die Ausbildung des Meniskus zur Beschichtung.

Die Form der Vertiefung, kann in Abhängigkeit des Fließverhaltens der Beschichtungszusammensetzung gewählt werden. Dabei ergeben Vertiefungen mit gekrümmten Boden gerade bei anorganischen Solen besonders homogene Beschichtungen.

Über die Breite des Beschichtungskopfes weist die Vertiefung bevorzugt die gleiche Tiefe auf.

Üblicherweise ist die zu beschichtende Oberfläche ähnlich wie bei einer Tauchbeschichtung lotrecht ausgerichtet. Im Unterschied zur Tauchbeschichtung besteht allerdings mit der erfindungsgemäßen Vorrichtung die Möglichkeit, dass die zu beschichtende Oberfläche in einer von der Lotrichtung abweichenden Position ausgerichtet ist. Bevorzugt kann die Vorrichtung samt Beschichtungskopf um bis zu 15° zur Lotrichtung verkippt werden, wobei der Beschichtungskopf stets waagerecht ausgerichtet bleibt.

Der Beschichtungskopf ist bevorzugt senkrecht zu der zu beschichtenden Oberfläche ausgerichtet. Es ist aber auch möglich, den Beschichtungskopf selbst in Bezug auf die Oberfläche zu verkippen.

In einer Weiterbildung der Erfindung umfasst die Vorrichtung außerdem eine Halterung für das Substrat. Bevorzugt handelt es sich dabei um eine Vakuumhalterung, insbesondere mit Saugknöpfen, welche an der Rückseite des Substrats anhaften.
In einer weiteren Ausführungsform der Erfindung ist die Vorrichtung in einer bestimmten Atmosphäre angeordnet. Dadurch kann das Verdampfen der Beschichtungszusammensetzung und damit die Veränderung der Beschichtungszusammensetzung während der Beschichtung vermieden werden. Gleichzeitig kann auch die Grenzflächenspannung und damit die Qualität der Beschichtung genau kontrolliert werden. Auch ist es möglich, durch eine bestimmte Zusammensetzung der Atmosphäre sehr empfindliche Beschichtungen aufzutragen.
Die Vorrichtung kann außerdem noch Mittel umfassen, welche das beschichtete Substrat oder das noch nicht beschichtete Substrat einer bestimmten Reinigungs- und/oder Temperaturbehandlung unterziehen.
In einer weiteren Ausführungsform der Erfindung umfasst der Beschichtungskopf auch Mittel zur Abdichtung zwischen dem Beschichtungskopf und dem Substrat. Dies können beispielsweise flexible Lippen oder Borsten sein, welche am vorderen Ende des Bodens der Vertiefung und/oder auch an den seitlichen Begrenzungen der Vertiefung angebracht sind. Dadurch ist gewährleistet, dass die Beschichtungszusammensetzung nicht Austreten kann. jGemäß der Erfindung ist der Teil des Beschichtungskopfes mit der Vertiefung als austauschbare Vertiefungsvorrichtung ausgeführt. Dies bedeutet, dass die Vertiefung auf einfache Weise vom Beschichtungskopf abmontiert werden kann. Dadurch kann die Vorrichtung auf einfache Weise an unterschiedliche Beschichtungszusammensetzungen angepasst werden oder unterschiedliche Formen der Vertiefung für unterschiedliche Substrate verwendet werden.
Die austauschbare Vertiefungsvorrichtung umfasst mindestens ein Befestigungsmittel zur lösbaren Befestigung am Beschichtungskopf. Der Befestigungskopf weist ebenfalls entsprechende Befestigungsmittel zur Aufnahme der Vertiefungsvorrichtung auf.
Die Befestigung kann beispielsweise über Verschraubungen und/oder Klemmen erfolgen. In diesem Fall weist der Beschichtungskopf und die Vertiefungsvorrichtung entsprechende Ausgestaltungen auf.
Die austauschbare Vertiefungsvorrichtung umfasst neben den Befestigungsmitteln eine entsprechend ausgestaltete Vertiefung, wie vorstehend beschrieben.

Gemäß der Erfindung umfasst zumindest die austauschbare Vertiefungseinrichtung oder auch der Beschichtungskopf ein Flächenelement, beispielsweise ein Blech oder eine Platte, das den Boden der Vertiefung bildet. Die Seiten des Flächenelements weisen entsprechende Seitenwände auf, so dass die entstehende Vertiefung nach oben und zum Substrat hin offen ist.

Gemäß der Erfindung ist der Teil des Flächenelements Teil der Befestigungsmittel der austauschbaren Vertiefungseinrichtung. Dies kann dadurch erreicht werden, dass das Flächenelement einen planaren Bereich aufweist und einen weiteren Bereich aufweist, der den Boden der Vertiefung bildet. Über den planaren Bereich kann die Vertiefungsvorrichtung einfach am Beschichtungskopf, beispielsweise über eine Klemme, befestigt werden. Dies erleichtert den Austausch der Vertiefung. Auf diese Weise kann insbesondere bei Testanlagen auf einfache Weise eine Vielzahl von Beschichtungsköpfen getestet werden, um die Beschichtungseigenschaften der Vorrichtung zu optimieren.

Das Flächenelement ist bevorzugt als eine nach unten gebogene oder geknickte Lippe am Beschichtungskopf angeordnet, wobei die Vertiefung durch den nach unten ragenden Teil des Flächenelements und daran angebrachte Seitenwände gebildet wird. Bevorzugt weist das Flächenelement in diesem Bereich eine konkave Krümmung auf.

Das Flächenelement kann aus beliebigen Materialien sein.

Außerdem ist die Herstellung von Beschichtungsköpfen mit Vertiefungen insbesondere gekrümmten Boden aus Flächenelementen sehr einfach möglich, da diese einfach gebogen werden können. Die für die Vertiefung notwendigen Seitenwände können unproblematisch angebracht werden. Auch können solche Flächenelemente, z. B. Bleche, auch bei größerer Ausdehnung mit hoher Präzision verarbeitet werden.

Bei dem Substrat kann es sich um beliebige Materialien handeln. Besonders bevorzugt sind Substrate aus Glas, Kunststoff, Metall oder Keramik. Besonders bevorzugt handelt es sich um beschichtete oder unbeschichtete Glasplatten.

Des Weiteren betrifft die Erfindung ein Verfahren zum Beschichten von planaren Substraten, unter Verwendung der erfindungsgemäßen Vorrichtung.

Des Weiteren betrifft die Erfindung die Verwendung der erfindungsgemäßen Vorrichtung zum Beschichten von planaren Substraten.

Weitere Einzelheiten und Merkmale ergeben sich aus der nachfolgenden Beschreibung von bevorzugten Ausführungsbeispielen in Verbindung mit den Unteransprüchen. Hierbei können die jeweiligen Merkmale für sich alleine oder zu mehreren in Kombination miteinander verwirklicht sein. Die Möglichkeiten, die Aufgabe zu lösen, sind nicht auf die Ausführungsbeispiele beschränkt. So umfassen beispielsweise Bereichsangaben stets alle - nicht genannten - Zwischenwerte und alle denkbaren Teilintervalle.

Die Ausführungsbeispiele sind in den Figuren schematisch dargestellt. Gleiche Bezugsziffern in den einzelnen Figuren bezeichnen dabei gleiche oder funktionsgleiche bzw. hinsichtlich ihrer Funktionen einander entsprechende Elemente. Im Einzelnen zeigt:
- Fig. 1: Querschnitt durch eine Vorrichtung mit quaderförmiger Vertiefung;
- Fig. 2: Querschnitt durch eine Vorrichtung mit quaderförmiger Vertiefung;
- Fig. 3: Querschnitt durch eine Vorrichtung mit einer abgeschrägten Vertiefung;
- Fig. 4: Querschnitt durch eine Vorrichtung mit einer Vertiefung mit gekrümmten Boden;
- Fig. 5: verschiedene Ausführungsformen der Vertiefung des Beschichtungsblocks;
- Fig. 6: Querschnitt durch eine Ausführungsform der Vorrichtung;
- Fig. 7: Querschnitt durch einen Beschichtungskopf;
- Fig. 8: Querschnitt durch einen Beschichtungskopf mit gekrümmten Boden;
- Fig. 9: Schematische Darstellung einer austauschbaren Vertiefungsvorrichtung mit einem gewölbten Boden.

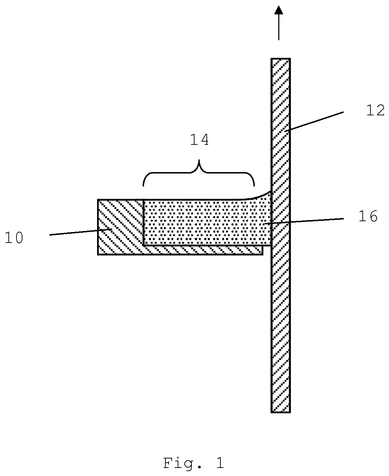

Fig. 1 zeigt eine schematische Darstellung der erfindungsgemäßen Vorrichtung. Der Beschichtungskopf 10 weist eine Vertiefung 14 auf, welche mit Beschichtungszusammensetzung 16 gefüllt ist. Der Beschichtungskopf ist so vor dem Substrat angeordnet, dass die Beschichtungszusammensetzung 14 die Oberfläche des Substrats 12 benetzt. Das Substrat wird in Richtung des Pfeils nach oben an dem Beschichtungskopf entlang bewegt. Aufgrund der Oberflächenspannung der Beschichtungszusammensetzung 16 kommt es zur Ausbildung eines Meniskus und zum Auftragen einer Beschichtung auf der Oberfläche des Substrats.

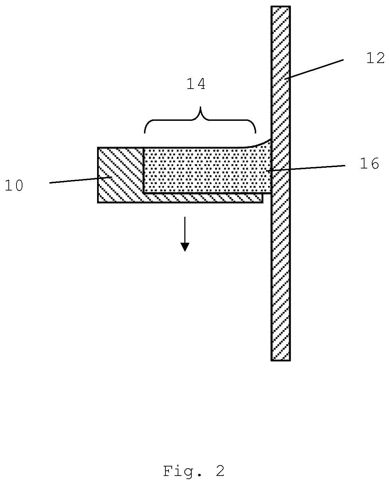

Fig. 2 zeigt eine schematische Darstellung der erfindungsgemäßen Vorrichtung analog zu Figur 1. In der Darstellung von Figur 2 bewegt sich der Beschichtungskopf 10 nach unten am Substrat entlang. Auch in diesem Fall bildet sich ein Meniskus und es kommt zur Beschichtung der Oberfläche des Substrats oberhalb des Beschichtungskopfes.

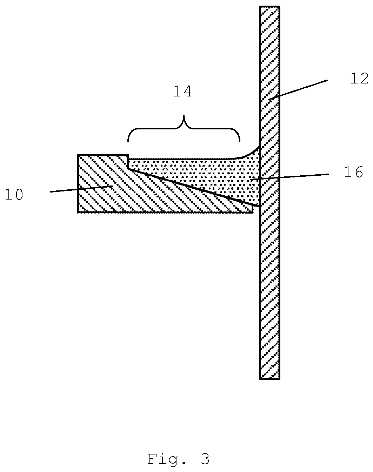

Fig. 3 zeigt eine schematische Darstellung einer Vorrichtung, bei der der Beschichtungskopf 10 eine Vertiefung 14 aufweist, welche einen abgeschrägten Boden besitzt. Die Tiefe der Vertiefung nimmt zum Substrat 12 hin zu.

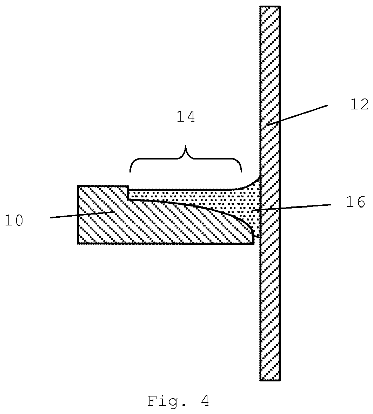

Fig. 4 zeigt eine weitere Ausführungsform der Erfindung, bei der die Vertiefung 14 im Beschichtungsblock 10 eine in Richtung zum Substrat 12 stärker als linear zunehmende Tiefe aufweist. Der Boden der Vertiefung ist gekrümmt.

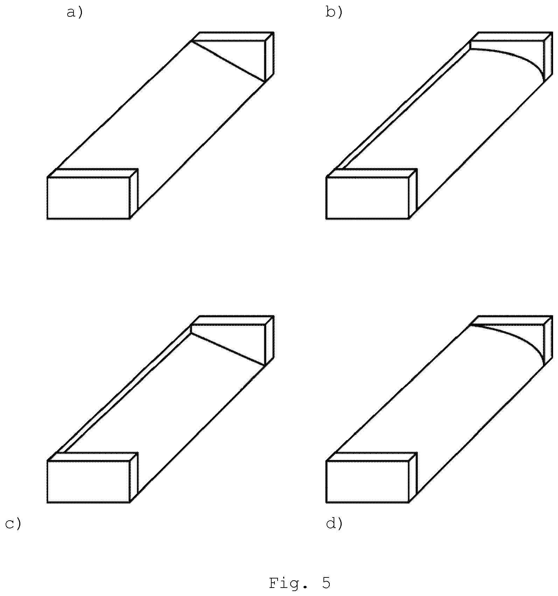

Fig. 5 zeigt unterschiedliche Varianten der Vertiefung des Beschichtungskopfes. So zeigen a) und c) Vertiefungen mit abgeschrägten Boden, während b) und d) Vertiefungen mit gekrümmten Boden zeigen. Die Darstellungen stellen nur schematisch die Form der Vertiefung dar. Der Beschichtungskopf kann noch weitere Merkmale umfassen.

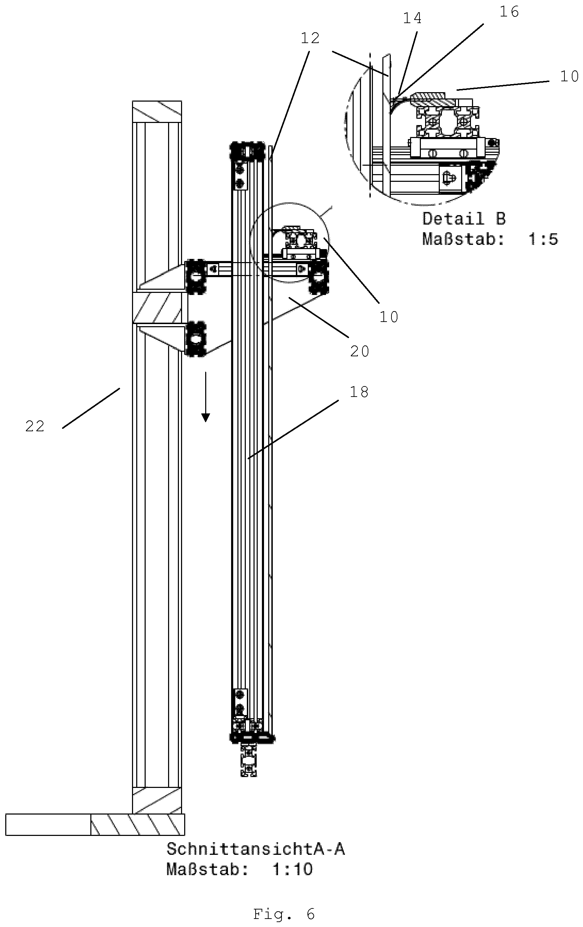

Fig. 6 zeigt einen Querschnitt durch eine Ausführungsform der erfindungsgemäßen Vorrichtung. Das Substrat 12 ist auf einer Halterung für das Substrat 18 angeordnet. Der Beschichtungskopf 10 ist auf einer Halterung 20 angeordnet, welche mit einer Bewegungsvorrichtung 22 verbunden ist. Entlang diese Bewegungsvorrichtung 22 kann sich die Halterung 20 relativ zum Substrat bewegen und auf diese Weise das Substrat beschichten. Der Ausschnitt zeigt den Beschichtungskopf 10 im Detail. Die Beschichtungszusammensetzung 16 ist in der Vertiefung 14 angeordnet.

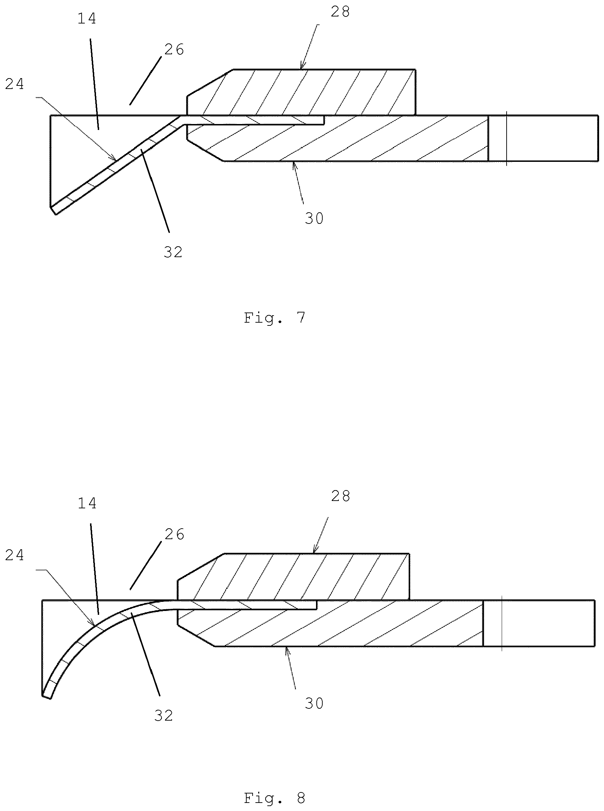

Fig. 7 zeigt einen Querschnitt durch eine' bevorzugte Ausführungsform des Beschichtungskopfes. Die Vertiefung 14 wird gebildet durch einen Boden 24, sowie den als Striche angedeuteten Seitenwänden 26. Der Boden 24 wird dabei durch ein Flächenelement 32 gebildet. Dieses Flächenelement ist teilweise auf einem Träger 30 angeordnet und wird durch eine Klemme 28 gehalten. Das gebogene Flächenelement 32 mit den Seitenwänden 26 bildet somit die austauschbare Vertiefungsvorrichtung. Durch Lösen der Klemme 28 kann die Vertiefungsvorrichtung einfach ausgetauscht werden.

Fig. 8 zeigt einen Querschnitt durch einen besonders bevorzugten Beschichtungskopf. Die Vertiefung 14 weist einen konkav gewölbten Boden 24 auf. Zusammen mit den Seitenwänden 26 bildet dieser Boden 24 die Vertiefung 14. Der Boden 24 der Vertiefung wird dabei durch ein Flächenelement 32 gebildet. Dieses Flächenelement ist durch einen Träger 30 und eine Klemme 28 mit dem Beschichtungskopf verbunden. Das gebogene Flächenelement 32 mit den Seitenwänden 26 bildet somit die austauschbare Vertiefungsvorrichtung.

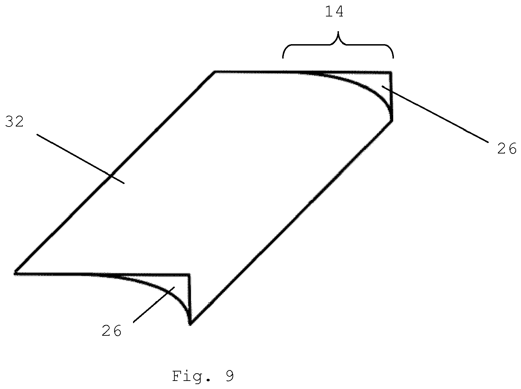

Fig. 9 zeigt eine schematische Darstellung der austauschbaren Vertiefungsvorrichtung aus Figur 8. Das Flächenelement 32 weist einen planaren Bereich und einen gekrümmten Bereich auf. An diesem gekrümmten Bereich sind Seitenwände 26 angebracht. Zusammen mit dem gekrümmten Bereich bilden diese die Vertiefung 14.

### Bezugszeichen

- 10: Beschichtungskopf
- 12: Substrat
- 14: Vertiefung
- 16: Beschichtungszusammensetzung
- 18: Substrathalterung
- 20: Halterung
- 22: Bewegungsvorrichtung
- 24: Boden der Vertiefung
- 26: Seitenwand
- 28: Klemme
- 30: Träger
- 32: Flächenelement

## Patentansprüche

1. Vorrichtung zum Auftragen einer Beschichtungszusammensetzung auf ein planares Substrat (12) umfassend
a) ein planares Substrat (12);
b) einen Beschichtungskopf (10) umfassend eine nach oben und zum Substrat hin offene Vertiefung (14) zur Aufnahme der Beschichtungszusammensetzung (16);
wobei das Substrat (12) und der Beschichtungskopf (10) relativ zueinander verschiebbar sind und
wobei der Beschichtungskopf (10) so angeordnet ist, dass das Substrat (12) durch die Beschichtungszusammensetzung (16) in der Vertiefung (14) benetzt wird und die Beschichtungszusammensetzung (16) durch die relative Bewegung auf das Substrat (12) aufgetragen wird, **dadurch gekennzeichnet, dass** der Teil des Beschichtungskopfes (10) mit der Vertiefung (14) austauschbar ausgeführt ist und ein Flächenelement (32) den Boden der Vertiefung (14) bildet.

2. Vorrichtung nach Anspruch 1, **dadurch gekennzeichnet, dass**
die Vertiefung (14) im Beschichtungskopf (10) ein Verhältnis von Breite zur Tiefe von mindestens 1:1 aufweist.

3. Vorrichtung nach einem der Ansprüche 1 oder 2, **dadurch gekennzeichnet, dass**
der minimale Abstand zwischen dem Beschichtungskopf (10) und der Oberfläche des Substrats (12) unter 2500 µm liegt.

4. Vorrichtung nach einem der Ansprüche 1 bis 3, **dadurch gekennzeichnet, dass**
die relative Bewegung mindestens eine senkrechte Komponente aufweist.

5. Vorrichtung nach einem der Ansprüche 1 bis 4, **dadurch gekennzeichnet, dass**
die Vertiefung (14) im Beschichtungskopf (10) eine zum Substrat hin zunehmende Tiefe aufweist.

6. Vorrichtung nach einem der Ansprüche 1 bis 5, **dadurch gekennzeichnet, dass**
sie eine Halterung für das Substrat (12) umfasst.

7. Vorrichtung nach einem der Ansprüche 1 bis 6, **dadurch gekennzeichnet, dass** das Flächenelement (32) einen planaren Bereich aufweist und einen weiteren Bereich aufweist, der den Boden der Vertiefung bildet.

8. Vorrichtung nach einem der Ansprüche 1 bis 7, **dadurch gekennzeichnet, dass** das Flächenelement (32) als eine nach unten gebogene oder geknickte Lippe am Beschichtungskopf angeordnet ist.

9. Verfahren zum Beschichten von planaren Substraten unter Verwendung einer Vorrichtung gemäß einem der Ansprüche 1 bis 8.

10. Verwendung einer Vorrichtung gemäß einem der Ansprüche 1 bis 8 zum Beschichten von planaren Substraten.

## Claims

1. Device for applying a coating composition to a planar substrate (12), comprising
a) a planar substrate (12);
b) a coating head (10) comprising a recess (14) for receiving the coating composition (16) said recess (14) being open upwardly and towards the substrate;
wherein the substrate (12) and the coating head (10) are displaceable relative to one another, and
wherein the coating head (10) is arranged such that the substrate (12) is wetted by the coating composition (16) in the recess (14), and the coating composition (16) is applied to the substrate (12) by the relative movement, **characterized in that** the part of the coating head (10) having the recess (14) is embodied in an exchangeable manner and a surface element (32) forms the bottom of the recess (14).

2. Device according to Claim 1, **characterized in that** the recess (14) in the coating head (10) has a ratio of width to depth of at least 1:1.

3. Device according to either of Claims 1 and 2, **characterized in that** the minimum spacing between the coating head (10) and the surface of the substrate (12) is less than 2500 µm.

4. Device according to one of Claims 1 to 3, **characterized in that** the relative movement has at least one perpendicular component.

5. Device according to one of Claims 1 to 4, **characterized in that** the recess (14) in the coating head (10) has a depth that increases towards the substrate.

6. Device according to one of Claims 1 to 5, **characterized in that** it has a holder for the substrate (12).

7. Device according to one of Claims 1 to 6, **characterized in that** the surface element (32) has a planar region and has a further region that forms the bottom of the recess.

8. Device according to one of Claims 1 to 7, **characterized in that** the surface element (32) is arranged on the coating head as a lip that is curved or bent downwards.

9. Method for coating planar substrates using a device according to one of Claims 1 to 8.

10. Use of a device according to one of Claims 1 to 8 for coating planar substrates.

## Revendications

1. Dispositif permettant de déposer une composition de revêtement sur un substrat plan (12), comprenant
a) un substrat plan (12) ;
b) une tête de revêtement (10) comprenant une cavité (14) ouverte vers le haut et vers le substrat pour contenir la composition de revêtement (16) ;
dans lequel le substrat (12) et la tête de revêtement (10) sont déplaçables l'un par rapport à l'autre, et
dans lequel la tête de revêtement (10) est disposée de telle manière que le substrat (12) soit mouillé par la composition de revêtement (16) dans la cavité (14) et que la composition de revêtement (16) soit déposée sur le substrat (12) par le mouvement relatif, **caractérisé en ce que** la partie de la tête de revêtement (10) avec la cavité (14) est échangeable et un élément plat (32) forme le fond de la cavité (14).

2. Dispositif selon la revendication 1, **caractérisé en ce que** la cavité (14) dans la tête de revêtement (10) présente un rapport de la largeur à la profondeur d'au moins 1:1.

3. Dispositif selon une des revendications 1 ou 2, **caractérisé en ce que** la distance minimale entre la tête de revêtement (10) et la surface du substrat (12) se situe en dessous de 2500 µm.

4. Dispositif selon l'une quelconque des revendications 1 à 3, **caractérisé en ce que** le mouvement relatif présente au moins une composante verticale.

5. Dispositif selon l'une quelconque des revendications 1 à 4, **caractérisé en ce que** la cavité (14) dans la tête de revêtement (10) présente une profondeur croissante en direction du substrat.

6. Dispositif selon l'une quelconque des revendications 1 à 5, **caractérisé en ce qu'**il comprend un support pour le substrat (12).

7. Dispositif selon l'une quelconque des revendications 1 à 6, **caractérisé en ce que** l'élément plat (32) présente une région plane et présente une autre région, qui forme le fond de la cavité.

8. Dispositif selon l'une quelconque des revendications 1 à 7, **caractérisé en ce que** l'élément plat (32) est disposé comme une lèvre incurvée ou pliée vers le bas sur la tête de revêtement.

9. Procédé pour revêtir des substrats plans en utilisant un dispositif selon l'une quelconque des revendications 1 à 8.

10. Utilisation d'un dispositif selon l'une quelconque des revendications 1 à 8 pour le revêtement de substrats plans.
